(19) **Europäisches Patentamt** / **European Patent Office** / **Office européen des brevets**

(11) **EP 3 624 123 B1**

(12) **FASCICULE DE BREVET EUROPEEN**

(45) Date de publication et mention de la délivrance du brevet:
**27.04.2022 Bulletin 2022/17**

(21) Numéro de dépôt: **19195816.4**

(22) Date de dépôt: **06.09.2019**

(51) Classification Internationale des Brevets (IPC):
**G11C 23/00** *(2006.01)* **G11C 11/50** *(2006.01)*
**H03K 19/00** *(2006.01)* **G11C 16/16** *(2006.01)*

(52) Classification Coopérative des Brevets (CPC):
**G11C 23/00; G11C 11/50; G11C 16/16; H03K 19/0019**

(54) **CELLULE DE MÉMORISATION EN LOGIQUE CAPACITIVE**

SPEICHERZELLE MIT KAPAZITIVER LOGIK

CAPACITIVE LOGIC STORAGE CELL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **11.09.2018 FR 1858125**

(43) Date de publication de la demande:
**18.03.2020 Bulletin 2020/12**

(73) Titulaire: **Commissariat à l'Energie Atomique et aux Energies Alternatives**
**75015 Paris (FR)**

(72) Inventeurs:
- **PERRIN, Yann**
  **38054 GRENOBLE CEDEX 9 (FR)**
- **FANET, Hervé**
  **38054 GRENOBLE CEDEX 9 (FR)**
- **GALISULTANOV, Ayrat**
  **38054 GRENOBLE CEDEX 9 (FR)**
- **PILLONNET, Gaël**
  **38054 GRENOBLE CEDEX 9 (FR)**

(74) Mandataire: **Cabinet Beaumont**
**4, Place Robert Schuman**
**B.P. 1529**
**38025 Grenoble Cedex 1 (FR)**

(56) Documents cités:
**US-A1- 2005 055 170**

- **GALISULTANOV A ET AL: "Contactless four-terminal MEMS variable capacitor for capacitive adiabatic logic", SMART MATERIALS AND STRUCTURES, IOP PUBLISHING LTD., BRISTOL, GB, vol. 27, no. 8, 12 juillet 2018 (2018-07-12), page 84001, XP020329191, ISSN: 0964-1726, DOI: 10.1088/1361-665X/AACAC4 [extrait le 2018-07-12]**

**Description**

Domaine technique

La présente description concerne le domaine des circuits logiques réalisés à base de condensateurs à capacité variable, aussi appelés circuits logiques capacitifs, et vise plus particulièrement la réalisation d'une cellule de mémorisation dans un circuit logique capacitif.

Technique antérieure

Le demandeur a déjà proposé, notamment dans la demande de brevet EP3182590 dans la demande de brevet français N°17/55419 déposée le 15 juin 2017 et dans la demande de brevet français N°17/57060 déposée le 25 juillet 2017 des exemples de réalisation de cellules logiques élémentaires à base de condensateurs à capacité variable à commande électromécanique.

L'utilisation de condensateurs à capacité variable à commande électromécanique pour mettre en oeuvre des fonctions logiques permet d'obtenir des circuits logiques à très faible consommation électrique. En particulier, cela permet d'éliminer les courants de fuite, qui sont un facteur limitant des circuits logiques classiques, et en particulier des circuits logiques réalisés à base de transistors.

Les demandes de brevet susmentionnées décrivent plus particulièrement la réalisation de cellules buffer inverseuses et non inverseuses, ainsi que d'un certain nombre de cellules logiques combinatoires de base, à partir de condensateurs à capacité variable à commande électromécanique.

Pour pouvoir réaliser des circuits plus complexes, il serait toutefois souhaitable de pouvoir disposer d'une cellule de mémorisation en logique capacitive. La présente demande concerne la réalisation d'une telle cellule de mémorisation. Le document US2005/055170 A1 et le document

XP020329191 (article intitulé "Contactless four-terminal MEMS Variable Capacitor for Capacitive Adiabatic Logic" de A. Galisultanov et al.) décrivent des exemples de condensateurs à capacité variable à commande électromécanique.

Résumé de l'invention

La présente invention est exposée dans une cellule de mémoire en logique capacitive selon la revendication indépendante 1, la cellule comportant:

- un système bistable comportant un élément fixe et un élément mobile susceptible de prendre l'une ou l'autre de deux positions stables par rapport à l'élément fixe ;
- un dispositif de lecture comportant un condensateur à capacité variable comprenant une première électrode fixe et une deuxième électrode mobile solidaire mécaniquement de l'élément mobile ; et
- un dispositif d'écriture commandable électriquement pour placer l'élément mobile dans l'une ou l'autre de ses deux positions stables,

dans laquelle le système bistable est :

a) un système électrostatique comprenant :

- une électrode fixe et une électrode mobile, l'électrode fixe comprenant deux parties conductrices connectées électriquement l'une à l'autre et disposées de part et d'autre de l'électrode mobile ;
- un ressort de rappel de l'électrode mobile dans une position de repos ; et
- un circuit d'application d'une tension de polarisation continue entre l'électrode fixe et l'électrode mobile, ou

b) un système électrodynamique comportant :

- une bobine conductrice fixe et un élément mobile en un matériau ferromagnétique disposé à l'intérieur de la bobine ;
- un ressort de rappel de l'élément mobile en un matériau ferromagnétique dans une position de repos ; et
- un circuit d'application d'un courant de polarisation (IP) continu entre des première et deuxième extrémités de la bobine.

Des aspects préférés de la présente invention sont définis dans les revendications dépendantes 2 à 8.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente de façon schématique un exemple d'une cellule capacitive de mémorisation selon un mode de réalisation ;

la figure 2 , ne tombant pas sous l'étendue de la protection conférée par les revendications annexées, représente schématiquement un exemple de réalisation d'un système bistable d'une cellule capacitive de mémorisation ;

la figure 3 représente schématiquement un autre exemple de réalisation d'un système bistable d'une cellule capacitive de mémorisation selon un mode de réalisation ;

la figure 4 illustre le fonctionnement du système bistable de la figure 3 ;

la figure 5 , ne tombant pas sous l'étendue de la protection conférée par les revendications annexées, représente schématiquement un exemple de réalisation d'un système bistable d'une cellule capacitive de mémorisation ;

la figure 6 représente schématiquement un autre exemple de réalisation d'un système bistable d'une cellule capacitive de mémorisation selon un mode de réalisation ;

la figure 7 représente schématiquement un autre exemple de réalisation d'un système bistable d'une cellule capacitive de mémorisation selon un mode de réalisation ;

la figure 8 représente schématiquement un autre exemple d'une cellule capacitive de mémorisation selon un mode de réalisation ;

la figure 9 , ne tombant pas sous l'étendue de la protection conférée par les revendications annexées, représente un exemple d'un circuit de lecture d'une cellule capacitive de mémorisation ; et

la figure 10 , ne tombant pas sous l'étendue de la protection conférée par les revendications annexées, représente schématiquement un autre exemple d'un circuit de lecture d'une cellule capacitive de mémorisation .

## Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation des diverses cellules logiques capacitives élémentaires susceptibles d'être utilisées, en combinaison des cellules de mémorisation décrites, dans un circuit logique capacitif, n'a pas été détaillée, la réalisation de ces cellules étant à la portée de l'homme du métier, notamment à la lecture des demandes de brevet susmentionnées précédemment déposées par le demandeur.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures, étant entendu que, en pratique, les dispositifs décrits peuvent être orientés différemment.

Sauf précision contraire, les expressions "environ", "approximativement", "sensiblement", et "de l'ordre de" signifient à 10 % près, de préférence à 5 % près.

Dans la présente description, on entend par plaque conductrice une plaque en un matériau apte à conduire des charges électriques, ce matériau pouvant être un matériau conducteur, par exemple un métal, ou encore un matériau semiconducteur, par exemple du silicium.

Dans les exemples décrits ci-après, les signaux logiques d'entrée et/ou de sortie d'une cellule correspondent de préférence à des tensions variables périodiques, dont l'amplitude détermine la valeur, haute ou basse, du signal logique. On parle alors de logique impulsionnelle ou logique dynamique dans la mesure où les états des signaux logiques d'entrée et/ou de sortie d'une cellule ne sont disponibles que pendant une fraction de la période d'un signal d'horloge formé par la tension d'alimentation de la cellule. De préférence, les tensions variables périodiques définissant les signaux logiques d'entrée et/ou de sortie des cellules sont des tensions à variation progressive, par exemple des tensions trapézoïdales, ce qui permet de réaliser des cellules présentant un fonctionnement adiabatique ou quasi-adiabatique. Alternativement, les signaux logiques d'entrée et/ou de sortie des cellules correspondent à des tensions continues dont le niveau détermine la valeur, haute ou basse, du signal logique. On parle alors de logique statique.

Sauf précision contraire, on entend par signal logique un signal ne pouvant prendre que deux états, un état haut (1 logique), correspondant par exemple à une amplitude ou à un niveau de tension proche de l'amplitude ou du niveau de la tension d'alimentation de la cellule, par exemple compris entre 3 et 15 volts, ou un état bas (0 logique), correspondant par exemple à une amplitude ou à un niveau de tension proche de 0 V, par exemple inférieur à 2 volts.

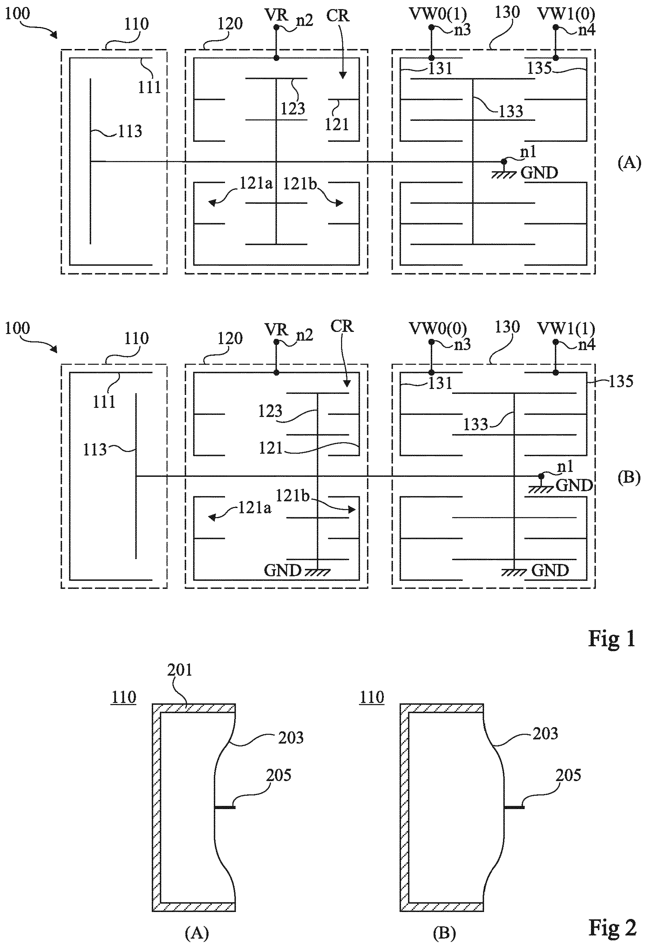

La figure 1 est une vue en coupe représentant de façon schématique un exemple d'une cellule capacitive de mémorisation 100 selon un mode de réalisation. La figure 1 comprend plus particulièrement deux vues (A) et (B) de la cellule de mémorisation 100. La vue (A), en partie haute de la figure 1, correspond à la configuration de la cellule lors d'une phase de mémorisation d'un premier état logique, par exemple un 0 logique, et la vue (B), en partie basse de la figure 1, correspond à la configuration de la cellule lors d'une phase de mémorisation d'un second état logique, par exemple un 1 logique.

La cellule de mémorisation 100 de la figure 1 comprend un système bistable 110 comportant un élément fixe 111 et un élément mobile 113. Par système bistable, on entend ici que l'élément mobile 113 présente uniquement deux positions d'équilibre stable par rapport à l'élément fixe 113. Des exemples de réalisation du système bistable 110 seront décrits plus en détail ci-après en relation avec les figures 2 à 7.

La cellule de mémorisation 100 de la figure 1 comprend en outre un dispositif de lecture 120 comprenant un condensateur à capacité variable CR comportant une électrode fixe 121 et une électrode mobile 123. L'électrode fixe 121 est solidaire mécaniquement de l'élément fixe 111 du système bistable 110, et l'électrode mobile 123 est solidaire mécaniquement de l'élément mobile 113 du système bistable 110. La capacité du condensateur de lecture CR est définie par la position relative de l'électrode mobile 123 par rapport à l'électrode fixe 121. Dans la mesure où l'élément mobile 113 ne peut prendre que l'une ou l'autre de deux positions stables par rapport à l'élément fixe 111, la capacité du condensateur CR ne peut prendre que l'une ou l'autre de deux valeurs stables : une valeur basse CR_LOW lorsque l'électrode mobile 123 et l'électrode fixe 121 du condensateur CR sont relativement éloignées l'une de l'autre, tel qu'illustré par la vue (A) de la figure 1, et une valeur haute CR_HIGH lorsque l'électrode mobile 123 et l'électrode fixe 121 du condensateur CR sont relativement proches l'une de l'autre, tel qu'illustré par la vue (B) de la figure 1.

La cellule de mémorisation 100 de la figure 1 comprend de plus un dispositif d'actionnement ou dispositif d'écriture 130, commandable électriquement pour faire passer l'élément mobile 113 du système bistable 110 de l'une quelconque à l'autre de ses deux positions d'équilibre, et donc la capacité du condensateur CR de sa valeur haute CR_HIGH à sa valeur basse CR_LOW ou inversement. Dans l'exemple de la figure 1, le dispositif 130 est un dispositif d'actionnement électrostatique comportant deux électrodes fixes 131 et 135 disposées de part et d'autre d'une électrode mobile 133. Les électrodes fixes 131 et 135 sont solidaires mécaniquement de l'élément fixe 111 du système bistable 110 et de l'électrode fixe 121 du dispositif de lecture 120, et l'électrode mobile 133 est solidaire mécaniquement de l'élément mobile 113 du système bistable 110 et de l'électrode mobile 123 du dispositif de lecture 120.

Dans l'exemple de la figure 1, les trois électrodes fixes 121, 131 et 135 de la cellule de mémorisation sont isolées électriquement les unes des autres. De plus, les électrodes mobiles 123 et 133 sont isolées électriquement des électrodes fixes 121, 131 et 135. Les électrodes mobiles 123 et 133 peuvent être isolées électriquement l'une de l'autre, ou connectées électriquement l'une à l'autre. Dans l'exemple de la figure 1, les électrodes mobiles 123 et 133 sont connectées à un même nœud n1 d'application d'un potentiel de référence GND, par exemple la masse. Les électrodes fixes 121, 131 et 135 sont quant à elles connectées respectivement à un nœud n2 d'application d'une tension de lecture VR, à un nœud n3 d'application d'une première tension d'écriture VW0 et à un nœud n4 d'application d'une deuxième tension d'écriture VW1. Dans cet exemple, les tensions de lecture VR et d'écriture VW0 et VW1 sont référencées par rapport au potentiel GND.

Le fonctionnement de la cellule de mémorisation 100 de la figure 1 va maintenant être décrit.

Pour écrire un 0 logique dans la cellule 100, les tensions VW0 et VW1 sont mises respectivement à un état haut et à un état bas. Autrement dit, une tension relativement élevée est appliquée entre l'électrode fixe 131 et l'électrode mobile 133 du dispositif d'actionnement 130, et une tension relativement faible est appliquée entre l'électrode fixe 135 et l'électrode mobile 133 du dispositif 130. Ainsi, une force électrostatique d'attraction est exercée par l'électrode fixe 131 sur l'électrode mobile 133, entrainant un déplacement dans une première direction (vers la gauche dans l'exemple de la figure 1) de l'ensemble de l'équipage mobile formé par les électrodes 133 et 123 et par l'élément 113. Ceci conduit à placer l'élément mobile 113 du système bistable 110 dans une première de ses deux positions d'équilibre stable, dans laquelle l'électrode mobile 123 du dispositif de lecture 120 est relativement éloignée l'électrode fixe 121 du dispositif 120, tel qu'illustré par la vue (A) de la figure 1.

Pour écrire un 1 logique dans la cellule, les tensions VW0 et VW1 sont mises respectivement à un état bas et à un état haut. Autrement dit, une tension relativement élevée est appliquée entre l'électrode fixe 135 et l'électrode mobile 133 du dispositif d'actionnement 130, et une tension relativement faible est appliquée entre l'électrode fixe 131 et l'électrode mobile 133 du dispositif 130. Ainsi, une force électrostatique d'attraction est exercée par l'électrode fixe 135 sur l'électrode mobile 133, entrainant un déplacement dans une deuxième direction opposée à la première direction (vers la droite dans l'exemple de la figure 1) de l'ensemble de l'équipage mobile formé par les électrodes 133 et 123 et par l'élément 113. Ceci conduit à placer l'élément mobile 113 du système bistable 110 dans sa deuxième position d'équilibre stable, dans laquelle l'électrode mobile 123 du dispositif de lecture 120 est relativement proche de l'électrode fixe 121 du dispositif 120, tel qu'illustré par la vue (B) de la figure 1.

En dehors des phases d'écriture, les tensions VW0 et VW1 sont par exemple toutes deux maintenues à un même état, par exemple un état bas, de sorte qu'aucune force électrostatique significative (c'est-à-dire suffisante pour faire changer d'état le système bistable 110) n'est exercée par les électrodes fixes 131 et 135 sur l'électrode mobile 133 du dispositif d'actionnement 130. Ainsi, le système bistable 110 conserve l'information stockée jusqu'à la prochaine opération d'écriture.

Les tensions VW0 et VW1 appliquées sur les électrodes fixes 131 et 135 du dispositif d'actionnement 130 correspondent par exemple à des signaux logiques fournis par d'autres cellules logiques capacitives (non détaillées ici) d'un circuit logique, par exemple des cellules logiques du type décrit dans les demandes de brevet susmentionnées précédemment déposées par le demandeur. En particulier, les tensions VW0 et VW1 peuvent être des tensions continues dans le cas d'un circuit réalisé en logique capacitive statique, ou des tensions variables périodiques dans le cas d'un circuit réalisé en logique capacitive dynamique.

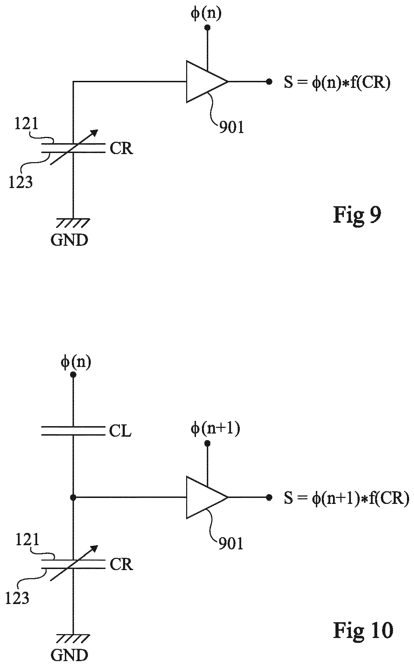

La valeur haute ou basse de la capacité du condensateur CR code l'état de la valeur logique stockée dans la cellule de mémorisation. La valeur logique stockée dans la cellule peut être lue par tout circuit de lecture adapté à fournir un signal logique de sortie dont l'état dépend de la valeur de la capacité du condensateur CR. Des exemples (non limitatifs) de circuits de lecture vont être décrit ci-après en relation avec les figures 9 et 10.

De préférence, l'agencement des électrodes fixe 121 et mobile 123 du dispositif de lecture est tel que :

- lorsqu'un 1 logique est mémorisé dans la cellule, c'est-à-dire lorsque la capacité du condensateur CR est à sa valeur haute CR_HIGH, la force électrostatique exercée par l'électrode fixe 121 sur l'électrode mobile 123 du fait de l'application de la tension de lecture VR soit dans la même direction que la force électrostatique exercée par l'électrode fixe 135 du dispositif d'actionnement 130 sur l'électrode mobile 133 du dispositif 130 lors d'une opération d'écriture d'un 1 logique dans la cellule (c'est-à-dire une force d'attraction vers la droite dans l'exemple de la figure 1) ; et

- lorsqu'un 0 logique est mémorisé dans la cellule, c'est-à-dire lorsque la capacité du condensateur CR est à sa valeur basse CR_LOW, la force électrostatique exercée par l'électrode fixe 121 sur l'électrode mobile 123 du fait de l'application de la tension de lecture VR soit inférieure à la force nécessaire pour faire changer de position d'équilibre l'élément mobile 113 du système bistable 110.

Ceci permet de prévenir tout changement d'état indésirable de la cellule mémoire sous l'effet de la tension de lecture VR.

Dans l'exemple de la figure 1, les électrodes 131, 133 et 135 du dispositif d'actionnement 130 sont des électrodes en forme de peignes interdigités, aussi appelées électrodes d'actuation à peignes ("comb-drive electrodes" en anglais). Plus particulièrement, dans l'exemple de la figure 1, les électrodes 131 et 135 ont chacune, en section, la forme d'un peigne simple, c'est-à-dire un peigne présentant une barre longitudinale et des dents perpendiculaires à la barre longitudinale s'étendant d'un seul côté de la barre longitudinale. L'électrode mobile 133 a quant à elle la forme d'un peigne double, c'est-à-dire un peigne présentant une barre longitudinale et des dents perpendiculaires à la barre longitudinale s'étendant des deux côtés de la barre longitudinale. En vue en perspective (non représentée), dans chaque électrode, les dents du peigne correspondent à des plaques conductrices sensiblement planes et parallèles entre elles, et la barre du peigne correspond à une plaque conductrice sensiblement plane et orthogonale aux dents du peigne. Dans cet exemple, les barres longitudinales des peignes 131, 133 et 135 sont sensiblement parallèles entre elles. Plus particulièrement, dans l'orientation de la figure 1, les barres longitudinales des peignes 131, 133 et 135 sont sensiblement verticales et les dents des peignes 131, 133 et 135 sont sensiblement horizontales. Les peignes fixes 131 et 135 sont placés en vis-à-vis l'un de l'autre, c'est-à-dire que les dents du peigne 131 sont tournées vers les dents du peigne 135, et réciproquement. Plus particulièrement, dans cet exemple, chaque dent du peigne 131 est sensiblement dans le même plan qu'une dent correspondante du peigne 135. Une distance non nulle sépare chaque dent du peigne 131 de la dent correspondante du peigne 135. Le peigne 133 est disposé entre les peignes 131 et 135, de façon que, d'un côté (du côté gauche dans l'orientation de la figure 1) de la barre longitudinale du peigne 133, chaque dent du peigne 133 soit disposée dans un plan intermédiaire entre deux dents voisines du peigne 131, par exemple sensiblement à équidistance des deux dents voisines du peigne 131, et que, de l'autre côté (du côté droit dans l'orientation de la figure 1) de la barre longitudinale du peigne 133, chaque dent du peigne 133 soit disposée dans un plan intermédiaire entre deux dents voisines du peigne 135, par exemple sensiblement à équidistance des deux dents voisines du peigne 135. L'électrode 133 est adaptée à se déplacer selon un unique degré de liberté en translation selon un axe horizontal entre les électrodes 131 et 135.

Lors d'une opération d'écriture d'un 0 logique dans la mémoire, une tension VW0 de niveau haut est appliquée sur l'électrode 131. Les dents du peigne 131 exercent alors une force électrostatique sur les dents de gauche du peigne 133, entrainant un déplacement horizontal vers la gauche du peigne 133. Lors d'une opération d'écriture d'un 1 logique dans la mémoire, une tension VW1 de niveau haut est appliquée sur l'électrode 135. Les dents du peigne 135 exercent alors une force électrostatique sur les dents de droite du peigne 133, entrainant un déplacement horizontal vers la droite du peigne 133.

Dans l'exemple de la figure 1, les électrodes 121 et 123 du dispositif de lecture 120 ont également la forme de peignes interdigités. Plus particulièrement, dans l'exemple de la figure 1, l'électrode 121 comprend deux peignes simples interconnectés 121a et 121b, disposés en vis-à-vis l'un de l'autre selon un agencement similaire à celui des peignes 131 et 135 du dispositif d'actionnement 130. L'électrode 123 a quant à elle la forme d'un peigne double disposé entre les peignes 121a et 121b, selon un agencement par rapport aux peignes 121a et 121b similaire à celui de l'électrode 133 par rapport aux peignes 131 et 135. L'électrode 123 est adaptée à se déplacer selon un unique degré de liberté en translation selon un axe horizontal entre les peignes 121a et 121b. Dans cet exemple, les peignes 121a, 121b et 123 sont disposés de façon que :

- lorsqu'un 0 logique est mémorisé dans la cellule, le peigne 123 soit sensiblement à équidistance des peignes 121a et 121b ; et
- lorsqu'un 1 logique est mémorisé dans la cellule, le peigne 123 soit plus proche du peigne fixe de gauche 121b que du peigne fixe de droite 121a.

Plus particulièrement, dans l'exemple représenté, les peignes 121a, 121b et 123 sont disposés de façon que :

- lorsqu'un 0 logique est mémorisé dans la cellule, les peignes 121a et 123 d'une part, et 121b et 123 d'autre part ne s'interpénètrent pas, d'où il résulte une valeur basse de capacité CR_LOW relativement faible ; et
- lorsqu'un 1 logique est mémorisé dans la cellule, les peignes 121b et 123 s'interpénètrent, d'où il résulte une valeur haute de capacité CR_HIGH relativement élevée.

Ainsi, lorsqu'un 0 logique est mémorisé dans la cellule, la force électrostatique exercée sur le peigne 123 par le peigne 121b sous l'effet de la tension de lecture VR est compensée par la force électrostatique sur le peigne 123 par le peigne 121a. La force résultante est donc sensiblement nulle. Lorsqu'un 1 logique est mémorisé dans la cellule, la force électrostatique exercée par le peigne 121b sur le peigne 123 est supérieure à la force électrostatique exercée par le peigne 121a sur le peigne 123. La force résultante est donc dans la même direction que la force électrostatique exercée par l'électrode fixe 135 du dispositif d'actionnement 130 sur l'électrode mobile 133 du dispositif 130 lors d'une opération d'écriture d'un 1 logique dans la cellule.

La figure 2 , ne tombant pas sous l'étendue de la protection conférée par les revendications annexées, représente schématiquement un système bistable 110 d'une cellule capacitive de mémorisation du type décrit en relation avec la figure 1. La figure 2 comprend plus particulièrement deux vues (A) et (B) du système bistable 110. La vue (A), en partie gauche de la figure 2, représente une première position d'équilibre stable du système, correspondant par exemple à la mémorisation d'un 0 logique dans la cellule, et la vue (B), en partie droite de la figure 2, représente une deuxième position d'équilibre stable du système, correspondant par exemple à la mémorisation d'un 1 logique dans la cellule.

Le système bistable de la figure 2 est un système purement mécanique, comportant un châssis fixe 201 (en traits hachurés sur la figure), et une barre ou poutre de flexion 203 fixée par ses extrémités au châssis 201. La poutre 203 présente une partie centrale suspendue, susceptible de se déplacer librement par rapport au châssis. Le système de la figure 2 comprend de plus une barre ou tige d'actionnement 205 fixée à la partie centrale de la poutre 203. Dans une première position d'équilibre stable, correspondant par exemple à la vue (A) de la figure 2, la poutre 203 présente, dans sa direction longitudinale, une forme courbée, par exemple une forme bombée. La courbure longitudinale de la poutre peut résulter d'une compression appliquée entre ses extrémités lors de sa fixation au châssis 201, ou peut correspondre à la forme naturelle de la poutre. Lorsqu'une force orthogonale à la poutre 203 est appliquée sur la barre d'actionnement 205, en direction du centre de l'arc de courbure de la poutre, la poutre 203 peut passer, par flambage, dans une deuxième position d'équilibre stable, correspondant dans cet exemple à la vue (B) de la figure 2, dans laquelle la poutre présente, dans sa direction longitudinale, une forme courbée selon un sens de courbure opposé à celui de la première position d'équilibre stable.

Dans cet exemple, le châssis 201 correspond à l'élément fixe 111 (figure 1) du système bistable 110, et la barre d'actionnement 205 correspond à l'élément mobile 113 (figure 1) du système 110. La barre d'actionnement 205 est fixée aux électrodes mobiles 123 et 133 de la cellule de mémorisation de façon que, lors d'une opération d'écriture, le déplacement de l'électrode mobile 133 du dispositif d'actionnement 130 sous l'effet des tensions d'écriture VW0 et/ou VW1 provoque un basculement de la poutre 203 de l'une à l'autre de ses deux positions d'équilibre stable et un basculement de la capacité du condensateur CR de l'une à l'autre de ses valeurs haute CR_HIGH et basse CR_LOW.

Un avantage du système de la figure 2 est qu'il permet de réaliser une mémoire non volatile dans la mesure où le système bistable 110 est purement mécanique et conserve donc l'information stockée même en l'absence de toute polarisation électrique de la cellule de mémorisation.

Une limitation du système de la figure 2 résulte du fait que la barrière d'énergie $\Delta E$ séparant les deux états d'équilibre stable du système présente une valeur fixe dépendant de la géométrie de la poutre de flexion. Passer d'un état logique à l'autre dissipe donc une énergie au moins égale à $2\Delta E$, ce qui empêche de changer d'état de façon adiabatique.

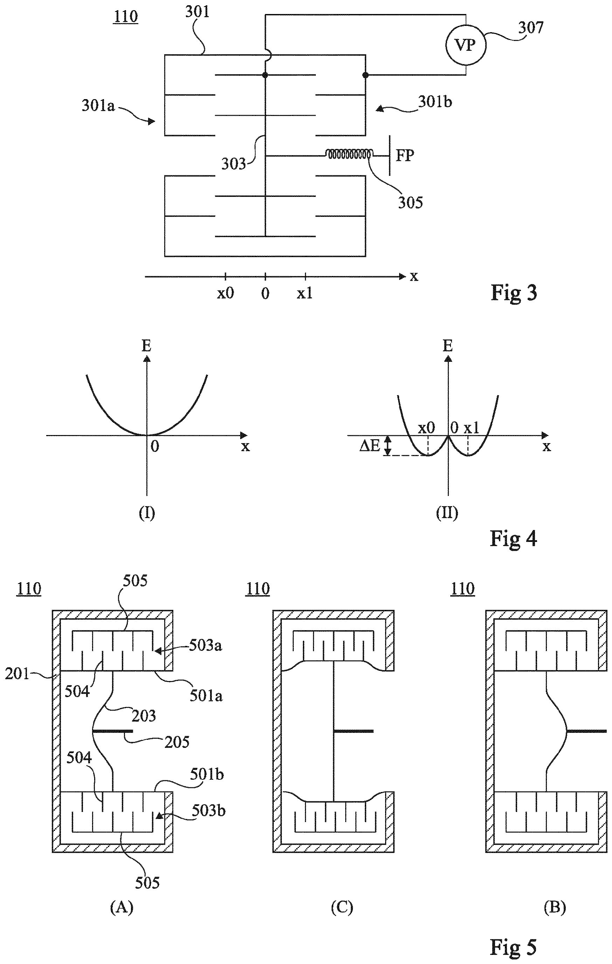

La figure 3 représente schématiquement un autre exemple de réalisation du système bistable 110 d'une cellule capacitive de mémorisation du type décrit en relation avec la figure 1.

Le système bistable de la figure 3 est un système électrostatique comportant une électrode fixe 301 et une électrode mobile 303. L'électrode fixe 301 comprend deux parties conductrices 301a et 301b solidaires mécaniquement l'une de l'autre et connectées électriquement l'une à l'autre, disposées de part et d'autre de l'électrode mobile 303. Dans l'exemple de la figure 3, l'électrode mobile 303 est adaptée à se déplacer selon un unique degré de liberté en translation selon un axe X horizontal. Les électrodes 301 et 303 sont agencées de façon que, lorsque l'électrode 303 se déplace selon l'axe X, la distance entre l'électrode 303 et la partie 301a de l'électrode 301 augmente et la distance entre l'électrode 303 et la partie 301b de l'électrode 301 diminue, ou inversement.

Le système bistable 110 de la figue 3 comprend en outre un ressort 305 de rappel de l'électrode mobile 303 dans une position de repos, c'est-à-dire une position d'équilibre stable en l'absence de polarisation électrique des électrodes 301 et 303. Le ressort 305 est par exemple un ressort de traction ou de compression ayant une première extrémité fixée à l'électrode mobile 303 et une deuxième extrémité fixée à un point fixe FP solidaire mécaniquement de l'électrode 301. Dans l'exemple représenté, la position de repos de l'électrode mobile 303 correspond à la position illustrée sur la figure 3, dans laquelle l'électrode 303 est située à équidistance des parties 301a et 301b de l'électrode 301. A titre de variante, la position de repos peut être une position dans laquelle l'électrode 303 est plus proche de la partie 301a de l'électrode 301 que de la partie 301b de l'électrode 301, ou inversement.

Le système bistable 110 de la figure 3 comprend en outre un circuit 307 d'application d'une tension de polarisation continue VP entre les électrodes 301 et 303.

La figure 4 illustre le fonctionnement du système bistable 110 de la figure 3. La figure 4 comprend plus particulièrement, en partie gauche de la figure, un premier diagramme (I) illustrant le comportement du système en l'absence d'application de la tension de polarisation VP entre les électrodes 301 et 303, et, en partie droite de la figure, un second diagramme (II) illustrant le comportement du système lorsqu'une tension de polarisation VP non nulle est appliquée entre les électrodes 301 et 303.

On note ici x la position de l'électrode 303 le long de l'axe X, la position x=0 correspondant à la position de repos de l'électrode 303, les positions x>0 correspondant aux positions dans lesquelles l'électrode 303 est plus proche de la partie 301b de l'électrode 301 que dans la position de repos, et les positions x<0 correspondant aux positions dans lesquelles l'électrode 303 est plus proche de la partie 301a de l'électrode 301 que dans la position de repos.

Chacun des diagrammes (I) et (II) représente plus particulièrement l'évolution, en fonction de la position x de l'électrode 303, de l'énergie potentielle E de l'électrode 303.

Lorsque la tension de polarisation VP est nulle, l'électrode mobile 303 subit uniquement une force de rappel élastique F définie comme suit :

$$[Math\ 1]$$

$$F = -k \times x$$

où k désigne la raideur du ressort 305.

L'énergie potentielle E de l'électrode 303 est purement élastique et se définit comme suit :

$$[Math\ 2]$$

$$E = \frac{1}{2} \times k \times x^2$$

La position x=0 est donc l'unique position d'équilibre stable du système comme l'illustre le diagramme (I) de la figure 4.

Lorsqu'une tension de polarisation VP non nulle est appliquée entre les électrodes 301 et 303, une énergie électrostatique s'ajoute à l'énergie élastique définie ci-dessus. L'énergie potentielle E de l'électrode 303 est alors définie comme suit :

$$[Math\ 3]$$

$$E = \frac{1}{2} \times k \times x^2 - \frac{1}{2} \times C \times VP^2$$

où C désigne la capacité du condensateur formé par les électrodes 301 et 303, définie comme suit :

$$[Math\ 4]$$

$$C = K \times |x|$$

K désignant un coefficient constant fonction de la géométrie des électrodes 301 et 303.

L'allure de l'énergie potentielle E de l'électrode 303 en présence d'une tension de polarisation non nulle est illustrée par le diagramme (II) de la figure 4. Elle présente deux minima locaux respectivement à une position x0<0 et à une position x1>0. Ces positions correspondent aux deux positions d'équilibre stable du système bistable. A titre d'exemple, la position x=x0 correspond à la mémorisation d'un 0 logique (vue (A) de la figure 1), et la position x=x1 correspond à la mémorisation d'un 1 logique (vue (B) de la figure 1).

Dans l'exemple de la figure 3, les électrodes 301 et 303 du système bistable 110 sont des électrodes en forme de peignes interdigités. Plus particulièrement, dans l'exemple de la figure 1, les parties 301a et 301b de l'électrode 301 ont chacune, en section, la forme d'un peigne simple. L'électrode mobile 303 a quant à elle la forme d'un peigne double. Dans cet exemple, les peignes 301a, 301b et 303 sont disposés selon un agencement identique ou similaire à celui des peignes 121a, 121b et 123 de la figure 1. A titre d'exemple, dans la position de repos du système, la structure formée par les électrodes 301a, 301b et 303 est symétrique par rapport à un axe vertical coïncidant sensiblement avec l'axe central de la barre longitudinale du peigne 303.

Dans cette configuration, dans le modèle du condensateur plan, la capacité C entre les électrodes 301 et 303 du système 110 peut s'exprimer comme suit :

[Math 5]

$$C = \frac{2 \times n \times e \times \varepsilon 0 \times |x|}{g}$$

où n désigne le nombre de dents d'un demi-peigne, e désigne l'épaisseur des plaques conductrices constituant les dents des peignes, g désigne la distance séparant chaque dent du peigne 303 des dents voisines du peigne 301a ou 301b, et ε0 désigne la permittivité du vide.

Les deux minima d'énergie potentielle de l'électrode 303 sont alors obtenus aux positions x0 et x1 suivantes :

[Math 6]

$$\begin{cases} x0 = -\dfrac{n \times e \times \varepsilon 0 \times |x|}{kg} \times VP^2 \\ x1 = +\dfrac{n \times e \times \varepsilon 0 \times |x|}{kg} \times VP^2 \end{cases}$$

La barrière d'énergie séparant les deux positions d'équilibre stable du système 110 est alors définie comme suit :

[Math 7]

$$\Delta E = \frac{1}{2k} \times \left( \frac{n \times e \times \varepsilon 0}{g} \right)^2 \times VP^4$$

Plus généralement, quelle que soit la géométrie des électrodes 301 et 303, la barrière d'énergie ΔE est une fonction croissante de la tension de polarisation continue VP.

Dans l'exemple de la figure 3, l'électrode fixe 301 correspond à l'élément fixe 111 (figure 1) du système bistable 110, et l'électrode mobile 303 correspond à l'élément mobile 113 (figure 1) du système 110. L'électrode mobile 303 est fixée aux électrodes mobiles 123 et 133 de la cellule de mémorisation de façon que, lors d'une opération d'écriture, le déplacement de l'électrode mobile 133 du dispositif d'actionnement 130 sous l'effet des tensions d'écriture VW0 et/ou VW1 provoque un basculement de l'électrode 303 de l'une à l'autre de ses deux positions d'équilibre stable et un basculement de la capacité du condensateur CR de l'une à l'autre de ses valeurs haute CR_HIGH et basse CR_LOW.

Ainsi, le système bistable de la figure 3 permet de conserver une information tant que la tension de polarisation continue VP est maintenue. L'information est en revanche perdue lorsque la tension de polarisation VP est interrompue, ce qui fait du système de la figure 3 un système de mémorisation volatile.

Un avantage du système de la figure 3 est que la barrière d'énergie ΔE séparant les deux états d'équilibre stable du système peut être abaissée en réduisant (en valeur absolue) temporairement la tension de polarisation continue VP lors d'une opération d'écriture d'une valeur logique dans la cellule de mémorisation. Ceci permet de mettre en oeuvre un changement d'état adiabatique ou quasi-adiabatique de la cellule.

La figure 5 , ne tombant pas sous l'étendue de la protection conférée par les revendications annexées, représente schématiquement un système bistable 110 d'une cellule capacitive de mémorisation du type décrit en relation avec la figure 1. La figure 5 comprend plus particulièrement trois vues (A), (B) et (C) du système bistable 110. La vue (A), en partie gauche de la figure 5, représente une première position d'équilibre stable du système, correspondant par exemple à la mémorisation d'un 0 logique dans la cellule, la vue (B), en partie droite de la figure 5, représente une deuxième position d'équilibre stable du système, correspondant par exemple à la mémorisation d'un 1 logique dans la cellule, et la vue (C), en partie centrale de la figure, représente une phase de transition entre les deux positions d'équilibre stable du système.

Le système bistable 110 de la figure 5 est un système mécanique comportant les mêmes éléments que le système de la figure 2, agencés pour fonctionner sensiblement de la même manière que dans le système de la figure 2. Le système de la figure 5 diffère du système de la figure 2 principalement en ce que, dans le système de la figure 5, les extrémités de la poutre de flexion 203 ne sont pas directement fixées au châssis fixe 201, mais sont reliées au châssis 201 par l'intermédiaire de ressorts, des moyens d'actionnement électrostatique étant prévus pour actionner les ressorts de façon à écarter ou rapprocher les points d'ancrage de la poutre, et ainsi modifier la valeur de la barrière d'énergie ΔE séparant les deux états d'équilibre stable de la poutre de flexion 203.

Dans l'exemple de la figure 5, le système comporte plus particulièrement deux lames ressort 501a et 501b sensiblement parallèles entre elles. Chacune des lames ressort 501a et 501b est fixée par ses extrémités au châssis fixe 201. Plus particulièrement, chacune des lames ressort 501a et 501b est suspendue par ses extrémités au châssis 201, une partie centrale de chaque lame étant libre de se déplacer par rapport au châssis 201 sous l'effet d'une déformation élastique de la lame. La poutre de flexion 203 a une première extrémité fixée à la partie centrale de la lame ressort 501a et une deuxième extrémité fixée à la partie centrale de la lame ressort 501b. Le système de la figure 5 comprend en outre un dispositif d'actionnement électrostatique 503a couplé à la lame ressort 501a et un dispositif d'actionnement électrostatique 503b couplé à la lame ressort 501b. Chaque dispositif d'actionnement comprend une première électrode 504 fixée à la partie centrale de la lame ressort, une deuxième électrode 505 fixée au châssis 201, et un circuit (non représenté) d'application d'une tension de polarisation continue entre les électrodes 504 et 505. Dans chacun des dispositifs d'actionnement 503a et 503b, Les électrodes 504 et 505 ont par exemple la forme de peignes interdigités. Dans chacun des dispositifs d'actionnement 503a et 503b, l'application d'une tension de polarisation entre les électrodes 504 et 505 conduit à modifier la position relative de l'électrode mobile 504 par rapport à l'électrode fixe 505, et donc la distance entre les extrémités de la poutre de flexion 203. Plus particulièrement, dans cet exemple, au repos, c'est-à-dire en l'absence de polarisation des électrodes 504 et 505, la poutre 203 présente une courbure longitudinale, et le comportement du système bistable est sensiblement identique à celui du système de la figure 2. Cette configuration correspond aux vues (A) et (B) de la figure 5. L'application d'une tension de polarisation continue non nulle entre les électrodes 504 et 505 conduit à écarter l'un de l'autre les deux points d'ancrage de la poutre de flexion 203, c'est-à-dire à tendre la poutre 203, et donc à diminuer voire annuler la courbure de la poutre 203. Cette configuration correspond à la vue (C) de la figure 5. Partant de cet état indéterminé, on peut écrire une valeur logique dans la cellule en brisant la symétrie de la poutre de flexion 203 en appliquant une force externe au moyen du dispositif d'actionnement 130 (figure 1), puis en abaissant la tension de polarisation appliquée entre les électrodes 504 et 505.

Ainsi, un avantage du système de la figure 5 est que la barrière d'énergie ΔE séparant les deux états d'équilibre stable du système peut être abaissée considérablement en appliquant une tension de polarisation entre les électrodes 504 et 505, ce qui permet de mettre en oeuvre un changement d'état adiabatique ou quasi-adiabatique de la cellule, tout en bénéficiant de l'avantage de non-volatilité du stockage procuré par l'utilisation d'un système bistable mécanique.

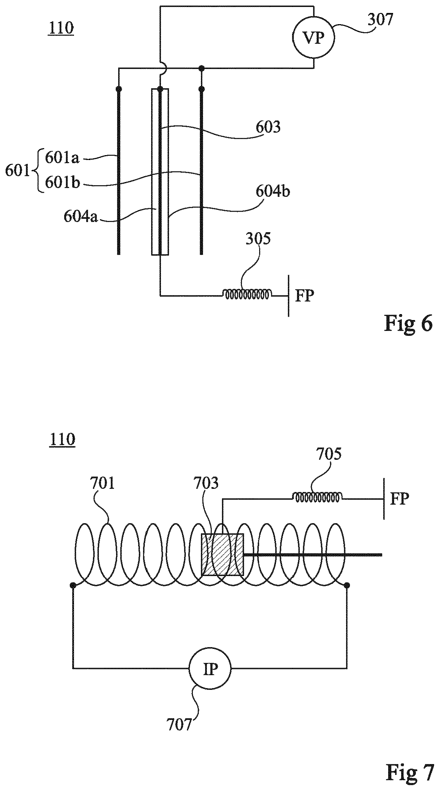

La figure 6 représente schématiquement un autre exemple de réalisation du système bistable 110 d'une cellule capacitive de mémorisation du type décrit en relation avec la figure 1.

Le système bistable de la figure 6 est un système électrostatique similaire au système de la figure 3, et diffère du système de la figure 3 principalement en ce que, dans le système de la figure 6, les actionneurs électrostatiques en forme de peignes interdigités du système de la figure 3 sont remplacés par des actionneurs électrostatiques plans.

Le système de la figure 6 comporte une électrode fixe 601 et une électrode mobile 603. L'électrode fixe 601 comprend deux parties conductrices 601a et 601b solidaires mécaniquement l'une de l'autre et connectées électriquement l'une à l'autre, disposées de part et d'autre de l'électrode mobile 603. Dans l'exemple de la figure 6, l'électrode 603 et les parties 601a et 601b de l'électrode 601 sont chacune constituées d'une plaque conductrice sensiblement plane. Les plaques 601a, 603 et 601b sont sensiblement parallèles entre elles. Dans l'exemple de la figure 6, les plaques 601a, 603 et 601b sont sensiblement verticales. La plaque mobile 603 est susceptible de se déplacer selon un unique degré de liberté en translation selon un axe horizontal de façon à diminuer la distance entre la plaque 603 et la plaque 601a et augmenter la distance entre la plaque 603 et la plaque 601b, ou inversement. Pour prévenir tout risque de court-circuit entre les électrodes 603 et 601, au moins l'une des deux faces en vis-à-vis des plaques 601a et 603 peut être revêtue d'une couche électriquement isolante, et au moins l'une des deux faces en vis-à-vis des plaques 601b et 603 peut être revêtue d'une couche électriquement isolante. Dans l'exemple représenté, la face de la plaque mobile 603 tournée vers la plaque 601a est revêtue par une couche électriquement isolante 604a, et la face de la plaque mobile 603 tournée vers la plaque 601b est revêtue par une couche électriquement isolante 604b.

Comme dans l'exemple de la figure 3, le système bistable 110 de la figue 6 comprend un ressort 305 de rappel de l'électrode mobile dans une position de repos, par exemple une position à équidistance des plaques conductrices 601a et 601b de l'électrode 601. De plus, comme dans l'exemple de la figure 2, le système bistable 110 de la figure 6 comprend en outre un circuit 307 d'application d'une tension de polarisation continue VP entre les électrodes 601 et 603.

Le fonctionnement du système de la figure 6 est similaire à celui du système de la figure 3, à savoir que, lorsque la tension de polarisation VP est nulle, l'électrode mobile 603 présente une unique position d'équilibre stable correspondant à sa position de repos, et, en présence d'une tension de polarisation continue VP non nulle, l'électrode mobile 603 présente deux positions d'équilibre stable, l'une plus proche de la plaque 601a que de la plaque 601b, et l'autre plus proche de la plaque 601b que de la plaque 601a.

La figure 7 représente schématiquement un autre exemple de réalisation du système bistable 110 d'une cellule capacitive de mémorisation du type décrit en relation avec la figure 1.

Le système bistable de la figure 7 est un système électrodynamique comportant une bobine conductrice fixe 701, et un élément mobile 703 en un matériau ferromagnétique, disposé à l'intérieur de la bobine 701. L'élément 703 est susceptible de se déplacer à l'intérieur de la bobine selon un unique degré de liberté en translation selon l'axe de la bobine 701 (horizontal dans l'exemple de la figure 7).

Le système bistable 110 de la figue 7 comprend en outre un ressort 705 de rappel de l'élément mobile 703 dans une position de repos, c'est-à-dire une position d'équilibre stable en l'absence de polarisation électrique de la bobine 701. Le ressort 705 est par exemple un ressort de traction ou de compression ayant une première extrémité fixée à l'élément mobile 703 et une deuxième extrémité fixée à un point fixe FP solidaire mécaniquement de la bobine 701. A titre d'exemple, dans la position de repos, l'élément mobile 703 se situe sensiblement au milieu de la bobine 701, à équidistance des deux extrémités de la bobine.

Le système bistable 110 de la figure 7 comprend en outre, connecté aux extrémités de la bobine 701, un circuit 707 d'application d'un courant de polarisation continu IP dans la bobine.

Le fonctionnement du système de la figure 7 est le suivant. Lorsque le courant de polarisation IP appliqué à la bobine est nul, l'élément mobile 703 présente une unique position d'équilibre stable, correspondant à sa position de repos. Lorsqu'un courant de polarisation continu non nul est appliqué à la bobine, ce courant induit un champ magnétique sensiblement homogène dans une partie centrale de la bobine, et très hétérogène au voisinage des extrémités de la bobine. Sous l'effet de ce champ magnétique, l'élément mobile 703 s'aimante, et est attiré par les régions à fort gradient de champ magnétique, c'est-à-dire par les extrémités de la bobine. Il existe alors deux positions d'équilibre stable de l'élément mobile 703, l'une plus proche de l'extrémité gauche de la bobine que de son extrémité droite, et l'autre plus proche de l'extrémité droite de la bobine que de son extrémité gauche.

Dans l'exemple de la figure 7, la bobine 701 correspond à l'élément fixe 111 (figure 1) du système bistable 110, l'élément 703 correspond à l'élément mobile 113 (figure 1) du système 110. L'élément mobile 703 est fixé aux électrodes mobiles 123 et 133 de la cellule de mémorisation de façon que, lors d'une opération d'écriture, le déplacement de l'électrode mobile 133 du dispositif d'actionnement 130 sous l'effet des tensions d'écriture VW0 et/ou VW1 provoque un basculement de l'électrode 103 de l'une à l'autre de ses deux positions d'équilibre stable et un basculement de la capacité du condensateur CR de l'une à l'autre de ses valeurs haute CR_HIGH et basse CR_LOW.

Le système de la figure 7 permet de conserver une information tant que le courant de polarisation IP est maintenu. L'information est en revanche perdue lorsque le courant IP est interrompu.

Dans le système de la figure 7, la barrière d'énergie ΔE séparant les deux états d'équilibre stable du système peut être abaissée en réduisant (en valeur absolue) temporairement le courant de polarisation continu IP lors d'une opération d'écriture d'une valeur logique dans la cellule de mémorisation, ce qui permet de mettre en oeuvre un changement d'état adiabatique ou quasi-adiabatique de la cellule.

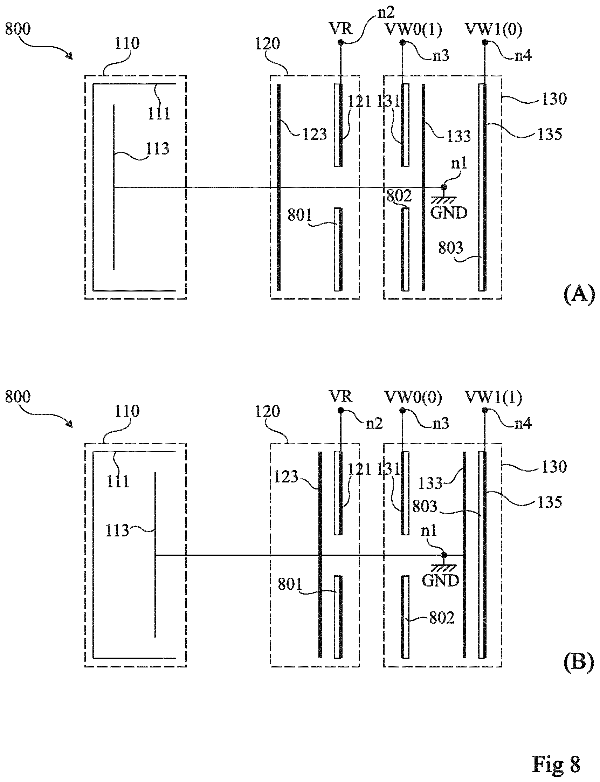

La figure 8 représente schématiquement un autre exemple d'une cellule capacitive de mémorisation 800 selon un mode de réalisation. La figure 8 comprend plus particulièrement deux vues (A) et (B) de la cellule de mémorisation 800. La vue (A), en partie haute de la figure 8, correspond à la configuration de la cellule lors d'une phase de mémorisation d'un premier état logique, par exemple un 0 logique, et la vue (B), en partie basse de la figure 8, correspond à la configuration de la cellule lors d'une phase de mémorisation d'un second état logique, par exemple un 1 logique.

La cellule de mémorisation 800 de la figure 8 est similaire à la cellule de mémorisation 100 de la figure 1, et diffère de la cellule 100 de la figure 1 principalement en ce que, dans la cellule 800, les actionneurs électrostatiques en forme de peignes interdigités du dispositif d'actionnement 130 de la cellule 100 sont remplacés par des actionneurs électrostatiques plans. De plus, dans la cellule 800, les électrodes en forme de peignes interdigités du dispositif de lecture 120 de la cellule 100 sont remplacées par des électrodes planes.

Dans l'exemple de la figure 8, les électrodes 121, 123, 131, 135 et 133 du dispositif de lecture 120 et du dispositif d'actionnement 130 sont chacune constituées d'une plaque conductrice sensiblement plane. Les plaques 121 et 123 sont sensiblement parallèles entre elles et en vis-à-vis l'une de l'autre. Les plaques 131, 133 et 135 sont sensiblement parallèles entre elles, la plaque 133 étant disposée entre les plaques 131 et 135, en vis-à-vis des plaques 131 et 135. Dans l'exemple de la figure 8, les plaques 121, 123, 131, 133 et 135 sont sensiblement verticales, les plaques 123 et 133 étant mobiles selon un unique degré de liberté en translation selon une direction horizontale, de façon à modifier la distance entre la plaque 121 et la plaque 123, et les distances respectives entre la plaque 131 et la plaque 133 et entre la plaque 133 et la plaque 135.

Pour prévenir tout risque de court-circuit entre les électrodes, au moins l'une des deux faces en vis-à-vis des plaques 121 et 123, au moins l'une des deux faces en vis-à-vis des plaques 131 et 133, et au moins l'une des deux faces en vis-à-vis des plaques 133 et 135, peuvent être revêtues d'une couche électriquement isolante. Dans l'exemple représenté, la face de la plaque 121 tournée vers la plaque 123 est revêtue par une couche électriquement isolante 801, la face de la plaque 131 tournée vers la plaque 133 est revêtue par une couche électriquement isolante 802, et la face de la plaque 135 tournée vers la plaque 135 est revêtue par une couche électriquement isolante 803.

La figure 9 , ne tombant pas sous l'étendue de la protection conférée par les revendications annexées, illustre schématiquement un exemple d'un circuit de lecture d'une cellule capacitive de mémorisation du type décrit ci-dessus. Dans cet exemple, le circuit de lecture comprend une cellule logique capacitive 901, par exemple une cellule buffer, dont l'entrée est reliée, par exemple connectée, à l'électrode 121 du condensateur CR, et dont la sortie est reliée, par exemple connectée, à un noeud de fourniture d'un signal de sortie S du circuit de lecture. La cellule buffer est par exemple une cellule du type décrit en relation avec la figure 2 ou 4 de la demande de brevet FR N°18/56243 déposée le 6 juillet 2018 par le demandeur, ou en relation avec la figure 2 ou 3 de la demande de brevet EP N°16204534.8 déposée le 15 décembre 2016 par le demandeur. Dans cet exemple, la cellule 901 est alimentée par une tension variable périodique φ(n), par exemple une tension trapézoïdale, et le signal de sortie S est une tension variable périodique en phase avec la tension d'alimentation φ(n), égale à φ(n)*f(CR), où f(CR) est un coefficient fonction de la valeur de la capacité du condensateur CR.

La figure 10 , ne tombant pas sous l'étendue de la protection conférée par les revendications annexées, illustre schématiquement un autre exemple d'un circuit de lecture d'une cellule capacitive de mémorisation du type décrit ci-dessus. Dans cet exemple, le circuit de lecture comprend, comme dans l'exemple de la figure 9, une cellule logique capacitive 901, par exemple une cellule buffer, dont l'entrée est reliée, par exemple connectée, à l'électrode 121 du condensateur CR, et dont la sortie est reliée, par exemple connectée, à un noeud de fourniture d'un signal de sortie S du circuit de lecture. Dans l'exemple de la figure 10, le circuit de lecture comprend en outre un condensateur à capacité fixe CL dont une électrode est reliée, par exemple connectée, à l'électrode 121 du condensateur CR et dont l'autre électrode est reliée, par exemple connectée, à un noeud d'application d'une tension d'alimentation variable périodique φ(n), par exemple une tension trapézoïdale. Dans l'exemple de la figure 10, la cellule 901 est alimentée par une tension variable périodique φ(n+1), par exemple de même forme et de même amplitude que la tension φ(n), mais en avance de phase de T=τ/4 sur la tension φ(n), τ désignant la période des tensions φ(n) et φ(n+1). Le signal de sortie S est alors une tension variable périodique en phase avec la tension d'alimentation φ(n+1), égale à φ(n+1)*f(CR), où f(CR) est un coefficient fonction de la valeur de la capacité du condensateur CR.

Divers modes de réalisation et variantes ont été décrits. L'homme de l'art comprendra que certaines caractéristiques de ces divers modes de réalisation et variantes pourraient être combinées, et d'autres variantes apparaitront à l'homme de l'art.

L'étendue de la protection de la présente invention est définie par les revendications ci-jointes 1-8.

**Revendications**

1.　Cellule de mémorisation (100 ; 800) en logique capacitive, comportant :

　　- un système bistable (110) comportant un élément fixe (111) et un élément mobile (113) susceptible de prendre l'une ou l'autre de deux positions stables par rapport à l'élément fixe ;

　　- un dispositif de lecture (120) comportant un condensateur à capacité variable (CR) comprenant une première électrode (121) fixe et une deuxième électrode (123) mobile solidaire mécaniquement de l'élément mobile (113) ; et

　　- un dispositif d'écriture (130) commandable électriquement pour placer l'élément mobile (113) dans l'une ou l'autre de ses deux positions stables,

**caractérisée en ce que** le système bistable (110) est :

　　a) un système électrostatique comprenant :

　　　　- une électrode fixe (301 ; 601) et une électrode mobile (303 ; 603), l'électrode fixe (301 ; 601) comprenant deux parties conductrices (301a, 301b ; 601a, 601b) connectées électriquement l'une à l'autre et disposées de part et d'autre de l'électrode mobile (303 ; 603) ;
　　　　- un ressort (305) de rappel de l'électrode mobile (303 ; 603) dans une position de repos ; et
　　　　- un circuit (307) d'application d'une tension de polarisation continue (VP) entre l'électrode fixe (301 ; 601) et l'électrode mobile (303 ; 603), ou

　　b) un système électrodynamique comportant :

　　　　- une bobine conductrice fixe (701) et un élément mobile (703) en un matériau ferromagnétique disposé à l'intérieur de la bobine (701) ;
　　　　- un ressort (705) de rappel de l'élément mobile (703) en un matériau ferromagnétique dans une position de repos ; et
　　　　- un circuit (707) d'application d'un courant de polarisation (IP) continu entre des première et deuxième extrémités de la bobine (701).

2.　Cellule (100 ; 800) selon la revendication 1, dans laquelle le dispositif d'écriture (130) est un dispositif électrostatique comprenant une troisième électrode (131) fixe, une quatrième électrode (135) fixe, et une cinquième électrode (133) mobile solidaire mécaniquement de l'élément mobile (113), la cinquième électrode (133) étant disposée entre les troisième (131) et quatrième (135) électrodes.

3.　Cellule (100) selon la revendication 2, dans laquelle les troisième (131), quatrième (135) et cinquième (133) électrodes ont la forme de peignes interdigités.

4.　Cellule (800) selon la revendication 2, dans laquelle les troisième (131), quatrième (135) et cinquième (133) électrodes ont la forme de plaques planes parallèles entre elles.

5. Cellule (100) selon l'une quelconque des revendications 1 à 4, dans laquelle les première (121) et deuxième (123) électrodes ont la forme de peignes interdigités.

6. Cellule (800) selon l'une quelconque des revendications 1 à 4, dans laquelle les première (121) et deuxième (123) électrodes ont la forme de plaques planes parallèles entre elles.

7. Cellule (100 ; 800) selon l'une quelconque des revendications 1 à 6, dans laquelle le système bistable (110) est un système selon l'alternative a) de la revendication 1, et dans laquelle l'électrode fixe (301) et l'électrode mobile (303) du système bistable (110) ont la forme de peignes interdigités.

8. Cellule (100 ; 800) selon l'une quelconque des revendications 1 à 6, dans laquelle le système bistable (110) est un système selon l'alternative a) de la revendication 1, et dans laquelle l'électrode fixe (601) et l'électrode mobile (603) du système bistable (110) ont la forme de plaques conductrices planes parallèles entre elles.

## Patentansprüche

1. Eine kapazitive logische Speicherzelle (100; 800), die Folgendes aufweist:

- ein bistabiles System (110) mit einem festen Element (111) und einem beweglichen Element (113), das in der Lage ist, die eine oder die andere von zwei stabilen Positionen in Bezug auf das feste Element einzunehmen;
- eine Lesevorrichtung (120) mit einem Kondensator (CR) mit variabler Kapazität, der eine erste feste Elektrode (121) und eine zweite bewegliche Elektrode (123) aufweist, die mechanisch mit dem beweglichen Element (113) verbunden ist; und-
- eine elektrisch steuerbare Schreibvorrichtung (130), um das bewegliche Element (113) in die eine oder die andere seiner beiden stabilen Positionen zu bringen,

dadurch gekennzeichnet, dass das bistabile System (110) Folgendes ist:

a) ein elektrostatisches System, das Folgendes aufweist:

- eine feste Elektrode (301; 601) und eine bewegliche Elektrode (303; 603), wobei die feste Elektrode (301; 601) zwei leitende Teile (301a, 301b; 601a, 601b) aufweist, die elektrisch miteinander verbunden und auf beiden Seiten der beweglichen Elektrode (303; 603) angeordnet sind;
- eine Rückstellfeder (305) zum Zurückführen der beweglichen Elektrode (303; 603) in eine Ruheposition; und
- eine Spannungsanlegungsschaltung (307) zum Anlegen einer Gleichvorspannung (VP) zwischen der festen Elektrode (301; 601) und der beweglichen Elektrode (303; 603),
oder

b) ein elektrodynamisches System, das Folgendes aufweist:

- eine feste leitende Spule (701) und ein bewegliches Element (703) aus einem ferromagnetischen Material, das innerhalb der Spule (701) angeordnet ist;
- eine Rückstellfeder (705) zum Zurückführen des beweglichen Elements (703) aus einem ferromagnetischen Material in eine Ruhestellung; und
- eine Stromanlegungsschaltung (707) zum Anlegen eines Vorspannungsgleichstroms (IP) zwischen einem ersten und einem zweiten Ende der Spule (701).

2. Zelle (100; 800) nach Anspruch 1, wobei die Schreibvorrichtung (130) eine elektrostatische Vorrichtung ist, die eine dritte feste Elektrode (131), eine vierte feste Elektrode (135) und eine fünfte bewegliche Elektrode (133) aufweist, die mechanisch mit dem beweglichen Element (113) verbunden ist, wobei die fünfte Elektrode (133) zwischen der dritten (131) und vierten (135) Elektrode angeordnet ist.

3. Zelle (100) nach Anspruch 2, wobei die dritte (131), vierte (135) und fünfte (133) Elektrode die Form von ineinandergreifenden Kämmen haben.

4. Zelle (800) nach Anspruch 2, wobei die dritte (131), vierte (135) und fünfte (133) Elektrode die Form von flachen Platten haben, die parallel zueinander sind.

5. Zelle (100) nach einem der Ansprüche 1 bis 4, wobei die erste (121) und die zweite (123) Elektrode die Form von ineinandergreifenden Kämmen haben.

6. Zelle (800) nach einem der Ansprüche 1 bis 4, bei der die erste (121) und die zweite (123) Elektrode die Form von flachen Platten haben, die parallel zueinander sind.

**7.** Zelle (100; 800) nach einem der Ansprüche 1 bis 6, wobei das bistabile System (110) ein System nach der Alternative a) des Anspruchs 1 ist, und wobei die feste Elektrode (301) und die bewegliche Elektrode (303) des bistabilen Systems (110) die Form von ineinandergreifenden Kämmen haben.

**8.** Zelle (100; 800) nach einem der Ansprüche 1 bis 6, wobei das bistabile System (110) ein System nach der Alternative a) des Anspruchs 1 ist, und wobei die feste Elektrode (601) und die bewegliche Elektrode (603) des bistabilen Systems (110) die Form von flachen leitenden Platten haben, die parallel zueinander sind.

**Claims**

**1.** A capacitive logic memory cell (100; 800), comprising:

- a bistable system (110) comprising a fixed element (111) and a mobile element (113) capable of taking one or the other of two stable positions with respect to the fixed element;
- a read device (120) comprising a variable-capacitance capacitor (CR) comprising a first fixed electrode (121) and a second mobile electrode (123) joined mechanically to the mobile element (113); and
- an electrically controllable write device (130) for placing the mobile element (113) in one or the other of its two stable positions,

**characterized in that** the bistable system (110) is:

a) an electrostatic system comprising:

- a fixed electrode (301; 601) and a mobile electrode (303; 603), the fixed electrode (301; 601) comprising two conductive parts (301a, 301b; 601a, 601b) electrically connected to each other and disposed on either side of the mobile electrode (303; 603);
- a return spring (305) for returning the mobile electrode (303; 603) to a rest position; and
- a voltage application circuit (307) for applying a direct bias voltage (VP) between the fixed electrode (301; 601) and the mobile electrode (303; 603),
or

b) an electrodynamic system comprising:

- a fixed conductive coil (701) and a mobile element (703) made of a ferromagnetic material disposed inside the coil (701) ;
- a return spring (705) for returning the mobile element (703) made of a ferromagnetic material to a rest position; and
- a current application circuit (707) for applying a direct bias current (IP) between first and second ends of the coil (701) .

**2.** The cell (100; 800) according to claim 1, wherein the write device (130) is an electrostatic device comprising a third fixed electrode (131), a fourth fixed electrode (135), and a fifth mobile electrode (133) joined mechanically to the mobile element (113), the fifth electrode (133) being disposed between the third (131) and fourth (135) electrodes.

**3.** The cell (100) according to claim 2, wherein the third (131), fourth (135) and fifth (133) electrodes have the form of inter-engaged combs.

**4.** The cell (800) according to claim 2, wherein the third (131), fourth (135) and fifth (133) electrodes have the form of flat plates that are parallel to one another.

**5.** The cell (100) according to any of claims 1 to 4, wherein the first (121) and second (123) electrodes have the form of inter-engaged combs.

**6.** The cell (800) according to any of claims 1 to 4, wherein the first (121) and second (123) electrodes have the form of flat plates that are parallel to each another.

**7.** The cell (100; 800) according to any of claims 1 to 6, wherein the bistable system (110) is a system in accordance with the alternative a) of claim 1, and wherein the fixed electrode (301) and the mobile electrode (303) of the bistable system (110) have the form of inter-engaged combs.

**8.** The cell (100; 800) according to any of claims 1 to 6, wherein the bistable system (110) is a system in accordance with the alternative a) of claim 1, and wherein the fixed electrode (601) and the mobile electrode (603) of the bistable system (110) have the form of flat conductive plates that are parallel to each other.

Fig 1

Fig 2

Fig 3

(I)

(II)

Fig 4

(A)

(C)

(B)

Fig 5

Fig 6

Fig 7

Fig 8

$\phi(n)$

$S = \phi(n)*f(CR)$

121

123

CR

901

GND

**Fig 9**

$\phi(n)$

CL

$\phi(n+1)$

$S = \phi(n+1)*f(CR)$

121

123

CR

901

GND

**Fig 10**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 3182590 A
- FR 1755419
- FR 1757060
- US 2005055170 A1
- FR 1856243
- EP 16204534

**Littérature non-brevet citée dans la description**

- **A. GALISULTANOV.** *Contactless four-terminal MEMS Variable Capacitor for Capacitive Adiabatic Logic*